# EUROPEAN PATENT SPECIFICATION

(11) **EP 0 890 184 B1**
(45) Date of publication and mention of the grant of the patent: **08.07.2009**
(21) Application number: 97915823.5
(22) Date of filing: 26.03.1997
(51) Int. Cl.: H01L 21/00

(54) **A METHOD FOR PRODUCING A SEMICONDUCTOR DEVICE HAVING A SEMICONDUCTOR LAYER OF SiC**
HERSTELLUNGSVERFAHREN FÜR EINE HALBLEITERANORDNUNG MIT EINER SiC SCHICHT
PROCEDE DE FABRICATION D'UN COMPOSANT A SEMI-CONDUCTEUR POSSEDANT UNE COUCHE DE SEMI-CONDUCTEUR EN SiC ET

(30) Priority: 27.03.1996 SE 9601174
(43) Date of publication of application: 13.01.1999
(73) Proprietor: CREE, INC., Durham, NC 27703 (US)
(72) Inventor: ROTTNER, Kurt, S-164 43 Kista (SE)
(74) Representative: Olsson, Jan
(86) International application number: PCT/SE1997/000533
(87) International publication number: WO 1997/036318

(56) References cited:
- GB-A- 1 201 428
- GB-A- 1 303 660
- GB-A- 1 397 305
- US-A- 4 801 555
- US-A- 4 851 360
- US-A- 4 914 500
- US-A- 5 021 851
- US-A- 5 322 805
- CARL-MIKAEL ZETTERLING: 'Process technology for silicon devices', THE INSTITUTION OF ELECTRICAL ENGINEERS, LONDON, UK pages 74-76
- 'The Encyclopaedia of Materials: Science and Technology', ELSEVIER SCIENCE LTD. pages 8505-8519
- CAPANO M.A. ET AL: 'Phosphorous Implantation into 4H-Silicon Carbide' JOURNAL OF ELETRONIC MATERIALS vol. 29, no. 2, 2000, page 210

## Description

### TECHNICAL FIELD OF THE INVENTION AND PRIOR ART

The present invention relates to a method for producing a semiconductor device having a semiconductor layer of SiC with at least a pn-junction therein, comprising a step a) of implanting an impurity dopant of a first conductivity type, being one of a) n and b) p, into said semiconductor layer being doped according to a second opposite conductivity type for forming a first type doped near surface layer in said semiconductor layer and a step b) of annealing said semiconductor layer at a high temperature for masking the implanted impurity dopants electrically active, as well as a semiconductor device produced by carrying out such a method.

Such an ion implantation technique may be used for production of all types of semiconductor devices, such as for example different types of diodes, transistors and thyristors, and it is an attractive technique in device fabrication as it allows control of both impurity level and distribution. This technique is well developed for Si-devices, but the method successfully used for ion implantation for such devices may not be utilized for SiC-devices, which are particularly used in applications in which it is possible to benefit from the superior properties of SiC in comparison with primarily Si, namely the capability of SiC to function well under extreme conditions. SiC has a high thermal stability due to a large bandgap energy, such that devices fabricated from said material are able to operate at high temperatures, namely up to 1000 K. Furthermore, it has a high thermal conductivity, so that SiC-devices may be arranged at a high density. SiC also has more than five times higher breakdown field than Si, so that it is well suited as a material in high power devices operating under conditions where high voltages may occur in the blocking state of the device.

Accordingly, it is highly desired to find means to control this technique of device fabrication also for SiC, so that doped high quality regions with a low defect density may be created in SiC by iron implantation.

When impurity dopants are implanted in SiC very high annealing temperatures, at least above 1300°C, are necessary. During the annealing some type of dopants starts to diffuse into the bulk of said semiconductor layer, which has one positive effect in that the physical pn-junction will be located away from the implanted region in the undisturbed semiconductor layer of SiC. But this outdiffusion at the surface is negative in that it causes very low concentrations of the dopants at the surface and thus it is difficult to form a good ohmic contact on such a device. When on the other hand a dopant which show a very low diffusitivity in SiC is implanted the dopant profile remains nearly as implanted after the annealing step, so that a highly doped near surface contact region with a low resistivity will be obtained, but the pn-junction will be located in a depth where a high concentration of defects is formed by the implantation, so that limitations in the breakdown behaviour as well as in emitter efficiency might be expected for such a semiconductor device.

### SUMMARY OF THE INVENTION

The object of the present invention is to find a remedy to the inconveniences discussed above by providing a new method of the type defined in the introduction.

This object is in accordance with the invention obtained by providing a method with the characteristics of the characterizing part of appended claim 1. By this type of combination of two different impurity dopants in an implantation step, it will be possible to benefit from the advantageous characteristic of each of them, so that the slowly diffusing element upon annealing will ensure the possibility to form a good ohmic contact on the semiconductor device, and the rapidly diffusing element will at the same time displace the pn-junction into a depth being at a considerable distance from the region damaged by the implantation, so that the active pn-junction will be located in an area of high crystalline perfection. "Slowly" and "rapidly" are to be interpreted broadly, and they do only state that one of the elements is diffusing with a considerably higher speed than the other at the temperature chosen for the anneal. As known, the diffusion rate is dependent on the temperature, so that it will theoretically be possible to chose one and the.same element as the slowly diffusing element at one annealing temperature and as the rapidly diffusing element at a higher annealing temperature.

According to a preferred embodiment of the invention two elements are implanted in said semiconductor layer in step a). The invention is not in any way restricted to the use of exactly two elements, but it will mostly be advantageous for the sake of simplicity to have only two elements.

According to another preferred embodiment of the invention said slowly and rapidly diffusing elements implanted in step a) are Group 3 B-elements. The elements belonging to this group have remarkably different diffusitivities in SiC at certain annealing temperatures and there is no problem to implant them as p-type dopants in SiC by ion-implantation, so that the result aimed at may in an advantageous way be achieved selecting these elements for the implantation.

According to another preferred embodiment of the invention aluminium is implanted in step a) as slowly diffusing element. Aluminium is at typical annealing temperatures following the ion-implantation in SiC very slowly diffusing, or nearly not diffusing at all, so that the near surface layer in the SiC-layer is kept highly doped even after the annealing step for allowing the formation of a good ohmic contact to a semiconductor device produced in this way.

Especially the combination of boron as rapidly diffusing element and aluminium as slowly diffusing element has turned out to lead to excellent results with a high concentration of dopants close to the surface of the SiC-layer and a pn-junction located far away from the region damaged by the implantation.

According to another preferred embodiment of the invention said annealing temperature in step b) is selected so as to make a certain implanted impurity dopant one of a) slowly and b) rapidly diffusing in said semiconductor layer of SiC. By using the annealing temperature as a parameter for controlling the diffusion speed different combinations of elements are possible. However, the annealing temperature may of course not be arbitrary varied, but it is necessary to select it at least so high that the implanted dopants are efficiently made electrically active by the annealing, and different problems may arise, such as the introduction of unwanted impurities, when the temperature is to high. Generally, the temperature necessary for the activation of the impurity dopants implanted will not be high enough for achieve any real diffusion into the SiC-layer.

According to another preferred embodiment of the invention said annealing step b) is carried out at a temperature above 1300°C. This has turned out to be a temperature level which has to be exceeded for a good annealing result.

According to another preferred embodiment of the invention said annealing step b) is carried out at a temperature above 1650°C. It has turned out that such temperatures are preferred for obtaining a diffusion rate being high enough for elements used as rapidly diffusing elements.

According to another preferred embodiment of the invention said at least one slowly diffusing element and said at least one rapidly diffusing element are in step a) implanted at such dose that said near surface layer become.s highly doped of both of them before the annealing step is carried out. Such a doping will lead to a good final result.

According to another preferred embodiment of the invention said concentration of dopants in the two previously described embodiments is above 10¹⁹ cm⁻³. Such a concentration is well obtainable and preferred for achieving a good final result after annealing.

Further preferred features and advantages of the invention will appear from the following description and the other dependent claims.

### BRIEF DESCRIPTION OF THE DRAWING

With reference to the appended drawing, below follows a specific description of a preferred embodiment of the invention cited as an example.

In the drawing:
Fig 1 and 2 illustrate very schematically two subsequent steps in a method for producing a semiconductor device having a semiconductor layer of SiC with at least a pn-junction therein,
Fig 3 and 4 are graphs illustrating the concentration (the logarithm thereof) of boron and aluminium, respectively, as a function of the depth in the SiC-layer into which they have been implanted before (dashed lines) and after (full lines) annealing,
Fig 5 is a graph corresponding to those of Fig 3 and 4 but showing the concentration of aluminium (dashed line) and boron (full line) as a function of the depth as implanted, and
Fig 6 is a graph of the concentration of aluminium (dashed line) and boron (full line) as a function of the depth after carrying out the annealing step.

### DETAILED DESCRIPTION OF A PREFERRED EMBODIMENT OF THE INVENTION

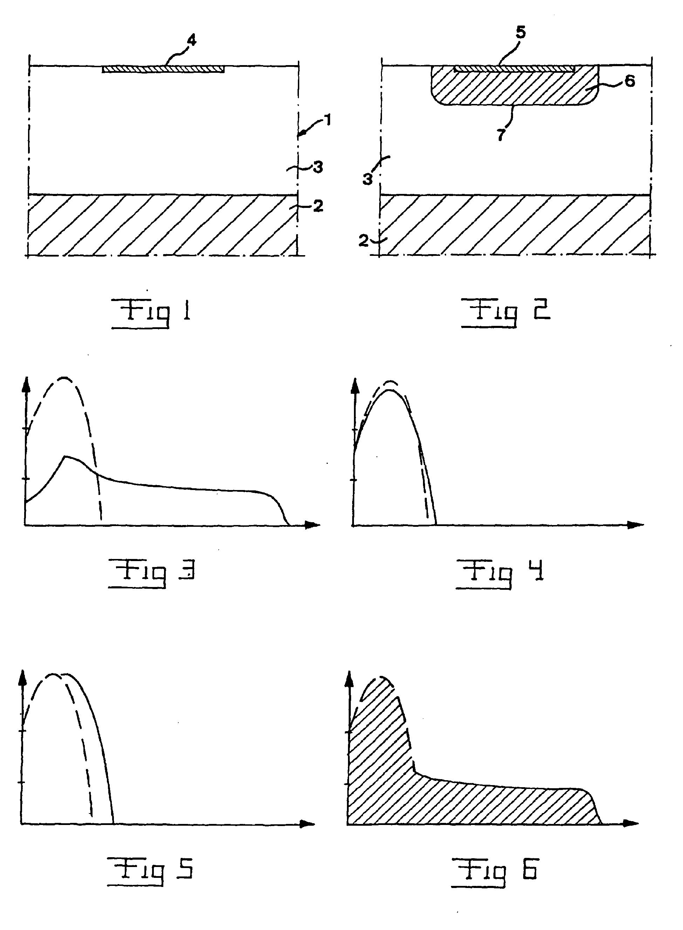

Fig 1 and 2 illustrate very schematically the two steps of implantation and annealing, respectively, of a method for producing a semiconductor device according to a preferred embodiment of the invention. The method do of course also comprise a lot of other steps conventional in the art, such as masking, demasking, passivation and so on, but these have not been illustrated, since they do not have anything to do with the inventional idea. A semiconductor layer 1 of SiC, preferably of a high crystalline, quality, is illustrated in Fig 1, and this semiconductor layer has a first highly doped n-type layer 2 forming a substrate for a low resistance contact to a cathode and a second low doped n-type layer 3 on top thereof, which is intended to form the drift layer of the device to be produced.

In a step a) the surface of the SiC semiconductor layer 1 is exposed to a bombardment of ions of aluminium and boron. The energy used for the bombardment of said surface by the ions is preferably in the range of 100 KeV - 4 MeV. A thin layer 4 having a thickness in the region of 10th of µm with a high concentration of dopants is in this way created. The concentration of aluminium in said thin layer 4 is preferably above 10¹⁹ cm⁻³, whereas the concentration of boron, i.e. the dopant intended to diffuse further into the SiC-layer in a following step, may be lower. These dopants are not electrically active after this implantation step, and the semiconductor layer 1 has to be heated to a temperature above 1300°C for obtaining such activation of the p-type dopants. If the annealing temperature is selected to be approximately 1700°C the boron will diffuse rapidly with respect to the aluminium into said SiC-layer 1 during said annealing. This annealing step will result in a thin surface layer 5 having primarily aluminium as p-type dopant and substantially corresponding to said thin layer 4 resulted from the implantation step, and a layer 6 having substantially boron as p-type dopant and extending deeper into the semiconductor layer for forming a pn-junction at a considerable distance from the surface region damaged by the implantation. The layer 6 will have a lower doping concentration than the layer 5, which thanks to the high doping concentration thereof will make it possible to form an excellent ohmic contact to the device there. In this way a rectifier diode has been produced, and the space charge region thereof is primarily provide by said second low-doped layer 3, which will take the main part of the voltage applied on the device in the reverse operating direction thereof, and such a device may have a breakdown voltage in the kV-range.

The graphs in Fig 3-6 explains how the advantageous semiconductor device shown in Fig 2 can be obtained through the steps of the method according to the invention described above. The horizontal axis in these figures indicates the depth and the vertical axis the logarithm of the concentration of the respective dopants. It is assumed that the same annealing temperature is used for all the examples according to Fig 3-6.

In Fig 3 it is shown by dashed lines how boron will be present in the semiconductor layer 1 as a function of the depth after implantation, and the full line shows the distribution of boron after the annealing step. Thus, boron diffuses comparatively far into said SiC-layer during the annealing step leaving only a comparatively small concentration thereof in the near surface region.

Fig 4 shows the distribution of aluminium as implanted (dashed line) and after the annealing (full line). Accordingly, aluminium is nearly not diffusing into the SiC-layer at all during said annealing step at the annealing temperature selected, so that the high concentration of aluminium remains near the surface after said annealing step.

Fig 5 shows the distribution of boron (full line) and aluminium (dashed line) after the implantation step of the method according to the invention, and Fig 6 shows the distribution of boron (full line) and aluminium (dashed line) after the annealing step of said method. Thus, Fig 6 illustrates clearly how a high concentration of dopants in the near surface layer for a good ohmic contact is combined with a pn-junction located comparatively deep in the undisturbed bulk of a high crystalline perfection by the implantation and annealing step of the method according to the invention.

It is emphasized that the graphs according to Fig 3-6 may have a similar appearance for other impurity dopants than aluminium and boron, and the invention is not only restricted to p-type dopants, but also n-type dopants are conceivable.

The invention is of course not in any way restricted to the preferred embodiment described above, but many possibilities to modifications thereof would be apparent to a man with ordinary skill in the art without departing from the basic idea of the invention.

In the implantation step it will be possible to implant the different elements simultaneously, but it would also be possible to first implant one of them and then the other.

That the semiconductor device produced has a semiconductor layer of SiC does not necessarily mean that the semiconductor device has SiC as the only semiconductor material, but only the region in which the implantation takes place and in which a pn-junction is formed by the diffusion has to be of SiC and the device may have hetero-character should this be desired.

The definition "semiconductor layer of SiC" includes that this SiC-layer may consists of several sub-layers as shown in the figures. Furthermore, the definition "layer" is to be interpreted broadly and comprises all types of volume extensions and shapes.

All definitions concerning the material of different layers of course also include inevitable impurities as well as intentional doping when SiC is concerned.

## Claims

1. A method for producing a semiconductor device having a semiconductor layer with at least a pn-junction (7) therein, comprising a step a) of implanting an impurity dopant of a first conductivity type, being one of a) n and b) p, into said semiconductor layer being doped according to a second opposite conductivity type for forming a first type doped near surface layer (4) in said semiconductor layer and a step b) of annealing said semiconductor layer at a high temperature for making the implanted impurity dopants electrically active,
**characterized in that** the semiconductor layer is of crystalline SiC and the combination that in step b) said annealing is carried out at such a high temperature that at least a portion of said dopants diffuses into the non-implanted sub-layer of said semiconductor layer following said near surface layer, that the annealing temperature is selected to be approximately 1700°C, that in step a) first conductivity type impurity dopants of at least two different elements are implanted in the semiconductor layer and that at least one of said elements is slowly diffusing in SiC at said annealing temperature and implanted at a dose corresponding to a concentration above 10¹⁹ cm⁻³ for retaining at high doping of said near surface layer after annealing for making it possible to form a good ohmic contact to said semiconductor layer and at least one of said elements is rapidly diffusing in SiC at said annealing temperature for locating pn-junction (7) so created at a considerable distance from said near surface layer and at a depth being at a considerable distance from the region damaged by the implantation locating the active pn-junction in an area of high crystalline perfection, that p-type impurity dopants are implanted in said semiconductor layer in step a,) and that boron is implanted in step a) as said rapidly diffusing element.

2. A method according to claim 1,
**characterized in that** first conductivity type impurity dopants of two different elements are implanted in said semiconductor layer in step a).

3. A method according to claim 1 or 2,
**characterized in that** said slowly and rapidly diffusing elements implanted in step a) are Group 3B-elements.

4. A method according to any of claims 1-3,
**characterized in that**, aluminium is implanted in step a) as slowly diffusing element.

5. A method according to any of claim 1-4,
**characterized in that**, gallium is implanted in step a) as slowly diffusing element.

6. A method according to any of claims 1-5,
**characterized in that**, said annealing temperature in step b) is selected so as to make a certain implanted impurity dopant.one of a) slowly and b) rapidly diffusing in said semiconductor layer of SiC.

7. A method according to any of claims 1-6,
**characterized in that**, said annealing in step b) is carried out at a temperature above 1300°C.

8. A method according to any of claims 1-7,
**characterized in that**, said annealing in step b) is carried out at a temperature above 1650°C.

9. A method according to any of claims 1-8,
**characterized in that**, both said at least one slowly diffusing element and said at least one rapidly diffusing element are in step a) implanted at such a dose that said near surface layer (4) becomes highly doped of both of them before the annealing step is carried out.

10. A method according to claim 9,
**characterized in that**, said dose corresponds to a concentration above 10¹⁹ cm⁻³.

## Patentansprüche

1. Verfahren zur Herstellung einer Halbleiteranordnung mit einer Halbleiterschicht mit wenigstens einer pn-Verbindung (7) darin, mit den folgenden Schritten
a) Implantieren eines Verunreinigungs-Dotierstoffs von einem ersten Leitfähigkeitstyp, welcher einer von a) n und b) p ist, in die Halbleiterschicht, welche gemäß einem zweiten entgegengesetzten Leitfähigkeitstyps dotiert ist, um einen ersten nahe der Oberflächenschicht (4) dotierten Typ in der Halbleiterschicht zu bilden und
b) Ausglühen der Halbleiterschicht bei einer hohen Temperatur, um die implantierten Verunreinigungs-Dotierstoffe elektrisch aktiv zu machen,
**dadurch gekennzeichnet,**
**daß** die Halbleiterschicht aus kristallinem SiC ist und durch die Kombination, daß in Schritt b) das Ausglühen bei einer solch hohen Temperatur ausgeführt wird, daß wenigstens ein Teil der Dotierstoffe in die nicht implantierte Unterschicht der Halbleiterschicht diffundiert, welche der nahen Oberflächenschicht folgt, daß die Ausglühtemperatur bei etwa 1.700°C ausgewählt ist, daß in Schritt a) Verunreinigungs-Dotierstoffe vom ersten Leitfähigkeitstyp von wenigstens zwei verschiedenen Elementen in die Halbleiterschicht implantiert werden und daß wenigstens eines der Elemente langsamer in SiC bei der Ausglühtemperatur diffundiert und mit einer Dosis implantiert wird, welche einer Konzentration von über 10¹⁹ cm⁻³ entspricht, um eine hohe Dotierung der nahen Oberflächenschicht nach dem Ausglühen zurückzulassen und es damit möglich zu machen, einen guten Ohmschen Kontakt der Halbleiterschicht zu bilden, und daß wenigstens eines der Elemente schnell in SiC bei der Ausglühtemperatur diffundiert, um eine pn-Verbindung (7) auszubilden, welche so in einer beträchtlichen Entfernung von der nahen Oberflächenschicht geschaffen wird und in einer Tiefe, welche in einer beträchtlichen Entfernung von dem Bereich ist, welcher durch die Implantation beschädigt ist, wobei die aktive pn-Verbindung in einem Bereich von hoher kristalliner Perfektion ausgebildet wird, und daß Verunreinigungs-Dotierstoffe vom p-Typ in der Halbleiterschicht in Schritt a) implantiert werden, und daß Bor in Schritt a) als das schneller diffundierende Element implantiert wird.

2. Verfahren nach Anspruch 1,
**dadurch gekennzeichnet,**
**daß** die Verunreinigungs-Dotierstoffe vom ersten Leitfähigkeitstyp von zwei verschiedenen Elementen in der Halbleiterschicht in Schritt a) implantiert werden.

3. Verfahren nach Anspruch 1 oder 2,
**dadurch gekennzeichnet,**
**daß** die schneller und langsamer diffundierenden Elemente, welche in Schritt a) implantiert werden, Gruppe 3B-Elemente sind.

4. Verfahren nach einem der Ansprüche 1 bis 3,
**dadurch gekennzeichnet,**
**daß** Aluminium in Schritt a) als langsamer diffundierendes Element implantiert wird.

5. Verfahren nach einem der Ansprüche 1 bis 4,
**dadurch gekennzeichnet,**
**daß** Gallium in Schritt a) als langsamer diffundierendes Element implantiert wird.

6. Verfahren nach einem der Ansprüche 1 bis 5,
**dadurch gekennzeichnet,**
**daß** die Ausglühtemperatur in Schritt b) so ausgewählt wird, um einen bestimmten implantierten Verunreinigungs-Dotierstoff mit einer entweder a) langsameren und b) schnelleren Diffusion in der Halbleitschicht aus SiC zu machen.

7. Verfahren nach einem der Ansprüche 1 bis 6,
**dadurch gekennzeichnet,**
**daß** das Ausglühen in Schritt b) bei einer Temperatur über 1.300°C ausgeführt wird.

8. Verfahren nach einem der Ansprüche 1 bis 7,
**dadurch gekennzeichnet,**
**daß** das Ausglühen in Schritt b) bei einer Temperatur über 1.650°C ausgeführt wird.

9. Verfahren nach einem der Ansprüche 1 bis 8,
**dadurch gekennzeichnet,**
**daß** beide des wenigstens einen langsamer diffundierenden Elements und des wenigstens einen schneller diffundierenden Elements in Schritt a) mit solch einer Dosis implantiert werden, daß die nahe Oberflächenschicht (4) hoch dotiert von beiden wird, bevor der Ausglühschritt ausgeführt wird.

10. Verfahren nach Anspruch 9,
**dadurch gekennzeichnet,**
**daß** die Dosis einer Konzentration über 10¹⁹ cm⁻³ entspricht.

## Revendications

1. Procédé de fabrication d'un dispositif semiconducteur ayant une couche semiconductrice avec au moins une jonction pn (7) dans celle-ci, comprenant une étape a) d'implanter une impureté de dopage d'un premier type de conductivité, qui est l'un de a) n et b) p, dans ladite couche semiconductrice qui est dopée selon un second type de conductivité opposé pour réaliser une couche près de la surface dopée d'un premier type (4) dans ladite couche semiconductrice et une étape b) d'anneler ladite couche semiconductrice à une température élevée pour rendre les impuretés de dopage implantées électriquement actives,
**caractérisé en ce que** la couche semiconductrice est en SiC cristallin et la combinaison que, dans l'étape b), ledit annelage est mis en oeuvre à une température élevée telle que au moins une partie desdits dopants se diffuse dans la sous-couche non implantée de ladite couche semiconductrice en suivant ladite couche près de la surface, que la température d'annelage est choisie pour être approximativement de 1700°C, que, dans l'étape a), des impuretés de dopage d'un premier type de conductivité d'au moins deux éléments différents sont implantées dans la couche semiconductrice et qu'au moins l'un desdits éléments se diffuse lentement dans SiC à ladite température d'annelage et est implanté à une dose correspondant à une concentration au-dessus de 10¹⁹cm⁻³ pour retenir un dopage important de ladite couche près de la surface après annelage pour permettre de former un bon contact ohmique avec ladite couche semiconductrice et au moins l'un desdits éléments se diffuse rapidement dans SiC à ladite température d'annelage pour maintenir une jonction pn (7) ainsi créée à grande distance de ladite couche près de la surface, à une profondeur qui est à grande distance de la région endommagée par l'implantation maintenant la jonction pn active dans une zone de grande perfection cristalline, que des impuretés de dopage de type p sont implantées dans ladite couche semiconductrice dans l'étape a), et que du bore est implanté dans l'étape a) en tant que ledit élément se diffusant rapidement.

2. Procédé selon la revendication 1,
**caractérisé en ce que** des impuretés de dopage du premier type de conductivité des deux éléments différents sont implantés dans ladite couche semiconductrice dans l'étape a).

3. Procédé selon la revendication 1 ou 2,
**caractérisé en ce que** lesdits éléments se diffusant lentement et rapidement, implantés dans l'étape a), sont des éléments du groupe 3B.

4. Procédé selon une quelconque des revendications 1-3,
**caractérisé en ce que** de l'aluminium est implanté dans l'étape a) en tant qu'élément se diffusant lentement.

5. Procédé selon une quelconque des revendications 1-4,
**caractérisé en ce que** du gallium est implanté dans l'étape a) en tant qu'élément se diffusant lentement.

6. Procédé selon une quelconque des revendications 1-5,
**caractérisé en ce que** ladite température d'annelage dans l'étape b) est choisie de manière à permettre une certaine impureté de dopage implantée de se diffuser a) lentement et b) rapidement dans ladite couche semiconductrice de SiC.

7. Procédé selon une quelconque des revendications 1-6,
**caractérisé en ce que** ledit annelage dans l'étape b) est mis en oeuvre à une température au-dessus de 1300°C.

8. Procédé selon une quelconque des revendications 1-7,
**caractérisé en ce que** ledit annelage dans l'étape b) est mis en oeuvre à une température au-dessus de 1650°C.

9. Procédé selon une quelconque des revendications 1-8,
**caractérisé en ce que** à la fois ledit élément se diffusant lentement et ledit élément se diffusant rapidement sont dans l'étape a) implantés à une dose telle que ladite couche près de la surface (4) devient fortement dopée des deux avant la mise en oeuvre de l'étape d'annelage.

10. Procédé selon la revendication 9,
**caractérisé en ce que** ladite dose correspond à une concentration au-dessus de 10¹⁹cm⁻³_{.}
